# EUROPEAN PATENT APPLICATION

(11) **EP 0 586 069 A2**
(43) Date of publication of application: **09.03.1994**
(21) Application number: 93305686.3
(22) Date of filing: 20.07.1993
(51) Int. Cl.: H01L 23/13, H01L 23/482

(54) **Memory module and packing method**

(30) Priority: 01.09.1992 KR 9215850
(71) Applicant: SAMSUNG ELECTRONICS CO., LTD., Suwon-city, Kyungki-do 441-373 (KR)
(72) Inventor: Kim, Kyung Sub, Kwanak-gu, Seoul (KR); Park, Khee, Socho-gu, Seoul (KR)
(74) Representative: Sturt, Clifford Mark

(57) **Abstract**

A memory module is disclosed wherein a piercing hole (58) is formed at the predetermined part of a module substrate (54) where a semiconductor package is to be inserted and a first semiconductor package (51) having gull-wing shaped external leads (56) is inserted so that the leads (56) are hung on the side edges of the piercing hole (58). Next, a second semiconductor package (52) is arranged on the external leads (56) of the first semiconductor package (51). Finally, the semiconductor packages are mounted by reflow soldering. Thus, the packing density can be improved as much as about two or three times in the same area and more packages can be mounted without changing the thickness of the memory module, thereby miniaturising the semiconductor device.

## Description

The present invention relates to memory modules, and more particularly to a memory module which achieves higher packing density by stack- mounting surface mounted semiconductor packages onto a module substrate having piercing holes where the packages are inserted.

In general, semiconductor packages which are surface-mounted on the printed circuit board (PCB) are divided into two types, according to the form of the external leads. One is the small out line package (SOP) which the external leads thereof are bent in the shape of gull-wing and the other is the small out line j form package (SOJ).

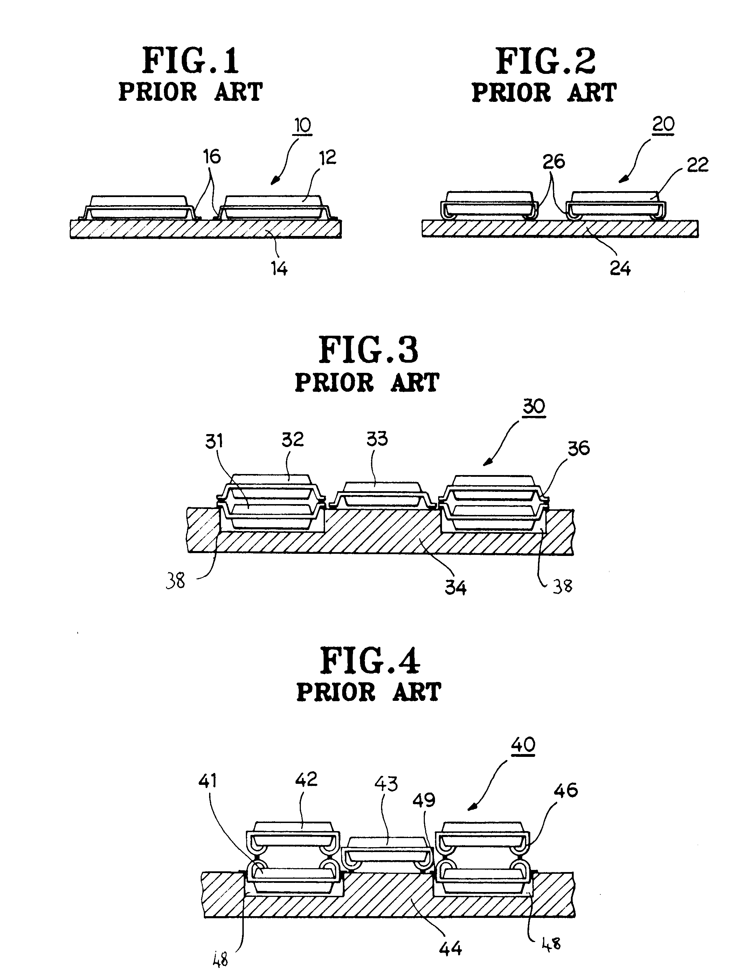

Figures 1 and 2 are cross-sectional views of conventional memory modules 10 and 20, and show memory modules 10 and 20 mounting SOP 12 and SOJ 22 packages, respectively.

Atone side of module substrates 14 and 24 where a single or multi metal layer is formed (not shown), a plurality of external leads 16 and 26 of semiconductor packages 12 and 22 are mounted by reflow soldering. In those memory modules, the semiconductor packages 12 and 22 are arranged only horizontally so that the packing density under a given area is lowered. Also, even when the semiconductor packages are stack-arranged to increase the packing density, the memory modules are thickened. Thus, they can not be used in thin products such as IC cards.

One proposal to solve these problems is disclosed in Korean patent number 91-24398. It is described with reference to figures 3 and 4.

At one side of each module substrate 34 and 44 where metal wirings are formed (not shown), slots 38 and 48 are respectively formed in a predetermined distance and, the external leads 36 and 46 of SOP type first semiconductor package 31 and SOJ type first semiconductor package 41 are mounted in the inside of the slots 38 and 48, confronting the outside of the slots 38 and 48. At that time, for the SOJ package case, additional pads 49 are prepared at the upper part of the inside of the slot 48 to be in contact with the external leads 46 of the SOJ type first package 41. Second semiconductor packages 32 and 42 are mounted on the external leads 36 and 46 of the first semiconductor packages 31 and 41 mounted in the slots 38 and 48. Also, third semiconductor packages 33 and 43 are mounted on the surface of the module substrates 34 and 44, respectively.

As described above, the memory module which mounts the semiconductor packages in the slot has a packing density one and half times larger than the module which mounts the semiconductor packages on its surface. However, if the total thickness of the semiconductor packages is larger than that of the module, it is difficult to miniaturise the memory module.

It is an object of the present invention to obviate or mitigate these problems and to provide a memory module which is able to mount more semiconductor chips under a given substrate area and thickness, thereby improving its packing density and miniaturising it.

According to the present invention, there is provided a module substrate where metal wirings are formed and a plurality of semiconductor packages, characterised by at least one piercing hole formed in said substrate;
a first semiconductor package located in each said piercing hole and having external leads engaging side edges of said piercing hole; and
a second semiconductor package mounted on the external leads of said first semiconductor package.

An embodiment of the present invention will now be described, by way of example only and with reference to the accompanying drawings, in which:-
Figure 1 is a cross-sectional view of an embodiment of a conventional memory module,
Figure 2 is a cross-sectional view of another embodiment of a conventional memory module,
Figure 3 is a cross-sectional view of another embodiment of a conventional memory module,
Figure 4 is a cross-sectional view of another embodiment of a conventional memory module,
Figure 5 is a cross-sectional view of an embodiment of a memory module according to the present invention, and
Figure 6 is a separated perspective view showing a memory module inserted into a socket.

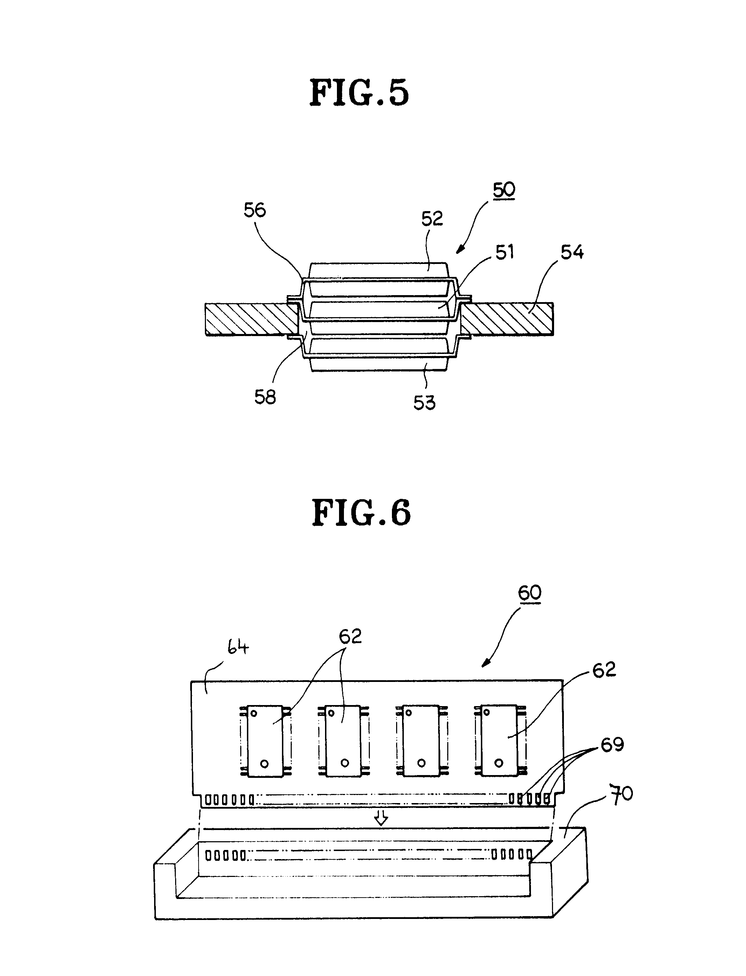

The present invention will now be described in more detail with reference to figures 5 and 6 of the accompanying drawings.

Figure 5 shows a cross-sectional view of an embodiment of a memory module according to the present invention.

At a predetermined part of a module substrate 54 where metal wirings (not shown) are formed, a piercing or through hole 58 is formed of a size sufficient to receive a first semiconductor package 51 inserted there. The first semiconductor package 51 having the gull-wing shaped external leads 56 is inserted into the hole 58 and external leads 56 are exposed at one side of the module substrate 54 to be connected with metal wirings. Then, a second semiconductor package 52 is mounted on the external leads 56 of the first package 51 and a third semiconductor package 53 is mounted on the other side of the module substrate 54 over the piercing hole 58. At both sides of the module substrate 54, metal wirings are formed for electrical connection between the first, the second, and the third semiconductor packages 51, 52 and 53. Also, pads (not shown) connected to the metal wirings, are formed at the position where the external leads 56 are to be laid.

Now, a process for manufacturing the memory module 50 is described in detail. First, the first semiconductor package 51 is reversely inserted into the piercing hole 58 of the module substrate 54 so that the end part of the external leads 56 is hung on the pads which are positioned at the jaw part or side edges of the piercing hole 58. Next, the second semiconductor package 52 is stack-mounted on the first semiconductor package 51 so that the end part of the external leads of the first and the second semiconductor packages are in register with each other. Subsequently, the two semiconductor packages 51 and 52 are mounted by vapour phase soldering (VPS) at about 215°C or infrared region (IR) soldering method. Finally, the third semiconductor package 53 is arranged at the bottom of the module substrate 54 in registerwith the two semiconductor packages 51 and 52 and is mounted by the soldering method.

As described above, the three semiconductor packages 51, 52 and 53 are sequentially stack-mounted, and the first semiconductor package 51 is completely localised in the piercing hole 58. Figure 6 shows the memory module 60 being inserted into a socket 70. The socket 70 is mounted on a mother board of semiconductor devices (not shown) and the memory module 60 has semiconductor packages 62 mounted in piercing holes in its module substrate 64. A terminal 69 formed at one side of the module substrate 64 is inserted into the socket 70 to be used as a sub-memory device. The above embodiment discloses a structure in which the packages are mounted at both sides of the module substrate but, in practice, the semiconductor packages can be stacked only at the top or the bottom side.

As described hereinabove, according to embodiments of the present invention, after forming the piercing hole of a sufficient size at the predetermined part of the module substrate where the semiconductor package is to be inserted, the first semiconductor package having the gull-wing shaped external leads is inserted so that the leads are hung on the side edges of the piercing hole. Next, the external leads of the second semiconductor package are arranged on the external leads of the first semiconductor package. Finally, the semiconductor packages are mounted by one-step reflow soldering. Thus, the packing density can be improved by as much as about two or three times in the same area and more packages can be mounted without changing the thickness of the memory module, thereby miniaturising the semiconductor device.

## Claims

1. A memory module comprising a module substrate (54) where metal wirings are formed and a plurality (51, 52) of semiconductor packages, characterised by at least one piercing hole (58) formed in said substrate (54);
a first semiconductor package (51) located in each said piercing hole (58) and having external leads (56) engaging side edges of said piercing hole (58); and
a second semiconductor package (52) mounted on the external leads (56) of said first semiconductor package (51).

2. A memory module as claimed in claim 1, wherein pads connected to the metal wirings are provided at the edges of said piercing hole (58) to be connected with the external leads (56) of said first semiconductor packages (51).
